# EUROPÄISCHE PATENTSCHRIFT

(11) **EP 0 799 912 B1**
(45) Veröffentlichungstag und Bekanntmachung des Hinweises auf die Patenterteilung: **07.07.1999**
(21) Anmeldenummer: 97103913.6
(22) Anmeldetag: 08.03.1997
(51) Int. Cl.: C25D 5/56

(54) **Verfahren zur galvanotechnischen Metallisierung von Kunststoffoberflächen**
Process for the electrolytic metallization of plastic surfaces
Procédé pour métalliser des surfaces en matière plastique par voie galvanique

(30) Priorität: 01.04.1996 DE 19613135
(43) Veröffentlichungstag der Anmeldung: 08.10.1997
(73) Patentinhaber: LPW-Chemie GmbH, 41460 Neuss (DE)
(72) Erfinder: Tolls, Elmar, Dr. Dipl.-Chem., 47877 Willich (DE); Köhl, Martin, 41462 Neuss (DE); Lesmeister, Stefan, 41466 Neuss (DE)
(74) Vertreter: Masch, Karl Gerhard, Dr.

(56) Entgegenhaltungen:
- US-A- 4 603 092

## Beschreibung

Die Erfindung betrifft ein Verfahren zur galvanotechnischen Metallisierung von Kunststoffoberflächen, wobei die zu metallisierende Kunststoffoberfläche außenstromlos mit einer metallischen Leitschicht metallisiert wird und im Anschluß daran elektrolytisch metallisiert wird.

Galvanotechnisch metallisierte Kunststoffe werden zu dekorativen Zwecken, unter anderem im Sanitärbereich oder bei der Automobilherstellung, eingesetzt. Ein Einsatz von metallisierten Kunststoffen findet aber auch im Rahmen der Beschichtung von Elektronikkomponenten zum Zwecke der elktromagnetischen Abschirmung statt. Für die galvanotechnische Metallisierung eignet sich eine Vielzahl von Kunststoffen. Im Rahmen von dekorativen Metallisierungen werden insbesondere Acrylnitril-Butadien-Styrol (ABS) oder Acrylnitril-Butadien-Styrol -Polycarbonat -Mischungen (ABS-PC-Blends) eingesetzt.

Im Rahmen des obengenannten Verfahrens wird die zu metallisierende Kunststoffoberfläche vor dem außenstromlosen Metallisieren zumeist vorgereinigt, anschließend zur Oberflächenaufrauhung gebeizt und danach mit Hilfe eines Edelmetalls aktiviert. Beizen meint dabei vorzugsweise das Anätzen der Kunststoffoberfläche mit Chromschwefelsäure oder alkalischer Permanganatlösung zur Aufrauhung der Oberfläche. Die Edelmetallaktivierung der Oberfläche findet vorzugsweise mit Palladium statt, beispielsweise mit Hilfe von ionogenen oder kolliodalen Palladiumlösungen. Es versteht sich, daß zwischen den einzelnen Verfahrensschritten, beispielsweise zwischen dem Beizen und der Edelmetallaktivierung, Spülmaßnahmen vorgesehen sein können. Nach dem Beizen mit starken Oxidationsmitteln wie Chromschwefelsäure oder Permanganat kann eine Reduktionsentgiftung zur Entfernung der Oxidationsmittel vorgesehen sein. Die bei der Edelmetallaktivierung störenden Oxidationsmittel können jedoch auch mit Hilfe von Hochenergieflüssigkeitsstrahlen entfernt werden. Vor der Edelmetallaktivierung findet vorzugsweise ein Vortauchen in verdünnter Salzsäure statt.

Bei dem bekannten Verfahren der eingangs genannten Art ("Kunststoffgalvanisierung", LPW-Taschenbuch für Galvanotechnik, Band 1, Verfahrenstechnik, 13. Ausgabe 1988, Seiten 443 bis 449), wird im Anschluß an die außenstromlose Aufbringung einer Nickelschicht als metallische Leitschicht zunächst eine weitere Nickelschicht zur Vorverstärkung elektrolytisch abgeschieden. Danach wird eine Kupferschicht aus einem schwefelsauren Glanzkupferbad entweder direkt auf der Vorverstärkungs-Nickelschicht elektrolytisch aufgebracht oder es wird vorher in einem Pyrophosphatbad vorverkupfert. Das Kupfer wird in einer Schichtdicke von mindestens 20 µm elektrolytisch aufgebracht, vorzugsweise in einer Schichtdicke von 30 µm. Im Anschluß daran werden weitere Metallschichten auf der Kupferschicht elektrolytisch abgeschieden. Der Schichtaufbau wird dabei je nach dem jeweiligen Verwendungszweck eingerichtet und umfaßt beispielsweise die elektrolytische Abscheidung von Glanznickel, Glanzchrom, Schwarzchrom, Zinn, usw.. Vorzugsweise findet eine elektrolytische Abscheidung von Glanznickel und Chrom statt. Der beschriebenen Kupfer-Zwischenschicht kommt im Rahmen der bekannten Maßnahmen erhebliche Bedeutung zu. Diese Kupferschicht nimmt im wesentlichen die Spannungen auf, die durch die unterschiedlichen Ausdehnungskoeffizienten von Kunststoff und Metall auftreten und trägt somit wesentlich dazu bei, daß Risse an der Oberfläche der metallisierten Kunststoffteile vermieden werden. Hierbei spielt die Schichtdicke der elektrolytisch aufgebrachten Kupferschicht sowie die physikalischen Eigenschaften der Kupferschicht, insbesondere minimale innere Spannungen und hohe Duktilität, eine entscheidende Rolle. Die Kupferschicht trägt im wesentlichen dazu bei, daß die nach dem bekannten Verfahren metallisierten Kunststoffoberflächen die Temperaturwechselprüfung nach DIN 53496 ohne weiteres bestehen. Risse auf der metallisierten Kunststoffoberfläche sind nach diesem Temperaturwechseltest nicht festzustellen. Das bekannte Verfahren hat sich insoweit bewährt, ist jedoch nichtsdestoweniger im Hinblick auf den Aufwand der Verfahrensführung und insbesondere bezüglich der Entsorgungsmaßnahmen verbesserungsbedürftig. Insbesondere stört, daß einerseits verhältnismäßig große Mengen an Spülwasser notwendig sind und andererseits die Abwasseraufbereitung relativ aufwendig ist.

Demgegenüber liegt der Erfindung das technische Problem zugrunde, ein Verfahren der eingangs genannten Art anzugeben, das sich durch geringen Aufwand auszeichnet und im Hinblick auf den Umweltschutz einfache und unproblematische Aufbereitungs- und Entsorgungsmaßnahmen gestattet.

Zur Lösung dieses technischen Problems lehrt die Erfindung, daß nach der außenstromlosen Metallisierung eine Halbglanznickelschicht aus einem Sulfamat-Nickel-Elektrolyten elektrolytisch abgeschieden wird und im Anschluß daran eine elektrolytische Abschlußbeschichtung der Kunststoffoberfläche, insbesondere eine elektrolytische Glanzmetallbeschichtung, aufgebracht wird, mit der Maßgabe, daß auf eine elektrolytische Abscheidung einer Kupfer-Zwischenschicht vor der elektrolytischen Abschlußbeschichtung verzichtet wird.

Der Erfindung liegt die Erkenntnis zugrunde, daß die bei dem eingangs beschriebenen bekannten Verfahren zwingend geforderte Kupfer-Zwischenschicht entfallen kann und durch die nach dem erfindungsgemäßen Verfahren unmittelbar auf die metallische Leitschicht aufgebrachte Halbglanznickelschicht ersetzt werden kann. Insofern ist anstelle der bekannten zweistufigen Verfahrensweise - elektrolytische Nickel-Vorverstärkung und anschließender elektrolytischer Abscheidung der Kupfer-Zwischensicht - lediglich die einstufige elektrolytische Abscheidung der Halbglanznickelschicht erforderlich, bevor die elektrolytischen Abschlußbeschichtungen aufgebracht werden. Von daher zeichnet sich das erfindungsgemäße Verfahren gegenüber dem bekannten Verfahren durch erheblich geringeren Aufwand aus. Nichtsdestoweniger genügt die nach dem erfindungsgemäßen Verfahren auf die Kunststoffoberfläche aufgebrachte Beschichtung im Hinblick auf mechanische und thermische Beanspruchungen allen Anforderungen. Überraschenderweise kann die erfindungsgemäß aufgebrachte Halbglanznickelschicht alle Spannungen aufnehmen, die durch die unterschiedlichen Ausdehnungskoeffizienten von Kunststoff und Metall auftreten. Die nach dem erfindungsgemäßen Verfahren beschichteten Kunststoffoberflächen genügen der Temperaturwechselprüfung nach DIN 53496 ohne weiteres, so daß Risse in den Metalloberflächen nicht festzustellen sind. Im Lichte des Standes der Technik muß es den Fachmann überraschen, daß die für zwingend erforderlich gehaltene Kupfer-Zwischenschicht durch die in wenig aufwendiger Weise erfindungsgemäß aufgebrachte Halbglanznickelschicht ersetzt werden kann. Besonders hervorzuheben ist, daß auch bei niedrigen Stromdichten für die elektrolytische Abscheidung des Halbglanznickels aus dem Sulfamat-Nickel-Elektrolyten temperaturwechselbeständige und spannungsfreie Nickelbeschichtungen erzeugt werden können.

Nach bevorzugter Ausführungsform der Erfindung wird die Halbglanznickelschicht in einer Schichtdicke von ungefähr 20 µm aufgebracht. Es liegt auch im Rahmen der Erfindung, Schichtdicken von 10 µm bis 50 µm vorzusehen. Zweckmäßigerweise wird ein Sulfamat-Nickel-Elektrolyt von handelsüblicher Zusammensetzung eingesetzt. Dabei kann das Sulfamat ganz oder teilweise durch die entsprechenden Salze kurzkettiger organischer Sulfonsäuren ersetzt sein. Günstig ist es auch, wenn der Sulfamat-Nickel-Elektrolyt Einebnerzusätze enthält. Weiterhin empfiehlt die Erfindung, die Halbglanznickelschicht in einer ersten Stufe mit normaler Stromdichte zum überwiegenden Teil der Schichtdicke und in einer anschließenden zweiten Stufe mit verminderter Stromdichte bis zur Sollschichtdicke aufzubringen; dabei kann in den beiden Stufen mit demselben Elektrolyten, aber auch unterschiedlichen Sulfamat-Nickel-Elektrolyten gearbeitet werden. Lange Elektrolytnutzungsdauer ist zu erwarten, wenn der Sulfamat-Nickel-Elektrolyt kontinuierlich durch Überleiten über ein Aktivkohlefilter gereinigt und von störenden Verunreinigungen befreit wird. Nach bevorzugter Ausführungsform der Erfindung wird im Rahmen der elektrolytischen Abschlußbeschichtung eine Glanznickelbeschichtung aufgebracht; vorzugsweise wird im Rahmen der elektrolytischen Abschlußbeschichtung glanzvernickelt und verchromt. Im übrigen empfiehlt es sich, zwecks Vermeidung von Poren die Elektrolyten durch Anwendung von Unterdruck und/oder einer gegenüber der Elektrolytbetriebstemperatur erhöhten Temperatur einer Entgasungsbehandlung zu unterwerfen, die vorzugsweise durch Keimbildner und/oder Ultraschall unterstützt wird.

Die auf die erfindungsgemäße Art und Weise metallisierten Kunststoffteile eignen sich insbesondere zum Einsatz in der Automobilindustrie und genügen beim Einsatz als Außenteile für Kraftfahrzeuge allen Anforderungen an den Korrosionsschutz. Dies gilt insbesondere für Außenteile mit einer Doppelnickelschicht, Halbglanznickelschicht und Glanznickelschicht in Kombination mit einer Verchromung zur Erzeugung von mikroporigem bzw. mikrorissigem Chrom. Dadurch, daß erfindungsgemäß die Halbglanznickelschicht anstelle von Kupfer eingesetzt wird, übernimmt die Halbglanznickelschicht die Funktion des edlen Nickels im Doppelnickelschichtsystem.

Das erfindungsgemäße Verfahren zeichnet sich zunächst durch den Vorteil aus, daß durch Ersatz der Kupfer-Zwischenschicht durch die Halbglanznickelschicht bei dem Galvanisieren beachtliche Mengen an Spülwasser eingespart werden können und die Zahl der Spülgänge reduziert werden kann. Dementsprechend fallen auch geringere Mengen an aufzubereitendem Abwasser an. Dies gilt insbesondere für die Ausführungsform, bei der im Zuge des außenstromlosen Metallisierens eine Nickel-Leitschicht aufgebracht wird und/oder für die Ausführungsform, bei der im Rahmen der elektrolytischen Abschlußbeschichtung eine elektrolytische Glanznickelbeschichtung aufgebracht wird. Durch Verzicht auf die Kupfer-Zwischenschicht wird erreicht, daß im wesentlichen lediglich nickelhaltiges Abwasser bzw. nickelhaltiger Schlamm anfallen, die auf relativ wenig aufwendige Weise aufbereitet bzw. gereinigt werden können. Im übrigen können im Rahmen von Recycling-Maßnahmen die kupferfreien und im wesentlichen nickelhaltigen Metallschichten von den metallisierten Kunststoffteilen abgetrennt werden und unmittelbar der Verhüttung zugeführt werden.

Im folgenden wird die Erfindung anhand von drei Ausführungsbeispielen näher erläutert:

### Ausführungsbeispiel 1:

Die Oberflächen von Kunststoffteilen aus Acrylnitril-Butadien-Styrol (ABS) wurden zunächst gemäß dem eingangs beschriebenen bekannten Verfahren vorgereinigt, zur Oberflächenaufrauhung gebeizt und danach mit Hilfe von Palladium aktiviert. Anschließend wurde außenstromlos eine Nickel-Leitschicht aufgebracht. Danach wurde unmittelbar in einem Zeitraum von 30 Minuten und einer Stromdichte von 5 A/dm² eine elektrolytische Glanznickelbeschichtung aufgebracht. Die glanzvernickelten Kunststoffteile zeigten ein ansprechendes dekoratives Aussehen. Es wurde eine Temperaturwechselprüfung nach DIN 53496, Beanspruchungsstufe 3, bei der im Temperaturintervall von + 80° C bis - 40° C gearbeitet wird, mit diesen Kunststoffteilen durchgeführt. Anschließend zeigten alle Kunststoffteile Risse.

### Ausführungsbeispiel 2:

Das Verfahren wurde zunächst wie im Ausführungsbeispiel 1 geführt, wobei jedoch nach der außenstromlosen Metallisierung mit der Nickel-Leitschicht eine Halbglanznickelschicht in bekannter Weise elektrolytisch mit einer Schichtdicke von 20 µm aufgebracht wurde. Der Elektrolyt enthielt 75 g/l Ni²⁺ als Nickelsulfat, 5 - 10 g/l Nickelchlorid, 40 g/l Borsäure und 0,3 g/l eines handelsüblichen Einebners. Bei einem pH-Wert von 4 - 4,5 wurde bei etwa 55° C mit einer Stromdichte von 5 A/dm² gearbeitet. Danach wurde eine elektrolytische Glanznickelbeschichtung mit einer Schichtdicke von 10 µm aufgebracht. Die obengenannte Temperaturwechselprüfung führte zu vergleichbaren Ergebnissen wie' im Ausführungsbeispiel 1. Alle Kunststoffteile wiesen Risse auf.

### Ausführungsbeispiel 3:

Das Verfahren wurde zunächst wie im Ausführungsbeispiel 1 geführt. Nach der außenstromlosen Metallisierung mit einer Nickel-Leitschicht wurde elektrolytisch eine Halbglanznickelschicht aus einem Sulfamat-Nickel-Elektrolyten mit handelsüblicher Zusammensetzung abgeschieden. Der Elektrolyt enthielt 110 g/l Ni²⁺ als Nickelsulfamat, 5 - 10 g/l Nickelchlorid, 40 g/l Borsäure und 0,5 g/l Netzmittel (Natriumsalz des sauren Schwefelsäureesters mit Dodecylalkohol); Arbeitsbedingungen: pH 4 - 4,5; 45° C; 5 A/dm². Die Schichtdicke der Halbglanznickelschicht betrug 20 µm. Daraufhin wurde eine elektrolytische Glanznickelbeschichtung in einem hoch einebnenden Nickelbad durchgeführt. Nach Durchführung der Temperaturwechselprüfung gemäß DIN 53496, Beanspruchungsstufe 3, wiesen diese, entsprechend dem erfindungsgemäßen Verfahren behandelten Kunststoffteile, keinerlei Risse auf. Die gleichen Ergebnisse wurden insbesondere auch in niedrigen Stromdichtebereichen für die elektrolytische Abscheidung der Halbglanznickelschicht erhalten. Die auf diese Weise nach dem erfindungsgemäßen Verfahren metallisierten Kunststoffteile weisen in bezug auf ihr Temperaturverhalten im Vergleich zu den nach dem bekannten Verfahren mit der Kupfer-Zwischenschicht hergestellten Kunststoffteilen vorteilhaftere Eigenschaften auf. Zusätzlich werden gegenüber dem bekannten Verfahren jedoch die oben bereits geschilderten Vorteile erzielt.

## Patentansprüche

1. Verfahren zur galvanotechnischen Metallisierung von Kunststoffoberflächen, wobei die zu metallisierende Kunststoffoberfläche außenstromlos mit einer metallischen Leitschicht metallisiert wird und im Anschluß daran elektrolytisch metallisiert wird, **dadurch gekennzeichnet,** daß nach der außenstromlosen Metallisierung eine Halbglanznickelschicht aus einem Sulfamat-Nickel-Elektrolyten elektrolytisch abgeschieden wird und im Anschluß daran eine elektrolytische Abschlußbeschichtung der Kunststoffoberfläche, insbesondere eine elektrolytische Glanzmetallbeschichtung, aufgebracht wird, mit der Maßgabe, daß auf eine elektrolytische Abscheidung einer Kupfer-zwischenschicht vor der elektrolytischen Abschlußbeschichtung verzichtet wird.

2. Verfahren nach Anspruch 1, dadurch gekennzeichnet, daß die Halbglanznickelschicht in einer Schichtdicke von 10 µm bis 50 µm, vorzugsweise 20 µm, aufgebracht wird.

3. Verfahren nach Anspruch 1 oder 2, dadurch gekennzeichnet, daß der Sulfamat-Nickel-Elektrolyt in einer Zusammensetzung eingesetzt wird, bei der das Sulfamat zumindest teilweise durch die entsprechenden Salze kurzkettiger organischer Sulfonsäuren ersetzt wird.

4. Verfahren nach einem der Ansprüche 1 bis 3, dadurch gekennzeichnet, daß der Sulfamat-Nickel-Elektrolyt Einebnerzusätze enthält.

5. Verfahren nach einem der Ansprüche 1 bis 4, dadurch gekennzeichnet, daß die Halbglanznickelschicht in einer ersten Stufe mit normaler Stromdichte zum überwiegenden Teil der Schichtdicke und in einer anschließenden zweiten Stufe mit verminderter Stromdichte bis zur Soll schichtdicke aufgebracht wird.

6. Verfahren nach Anspruch 5, dadurch gekennzeichnet, daß in den beiden Stufen mit unterschiedlichen Sulfamat-Nickel-Elektrolyten gearbeitet wird.

7. Verfahren nach einem der Ansprüche 1 bis 6, dadurch gekennzeichnet, daß der Sulfamat-Nickel-Elektrolyt kontinuierlich durch Überleiten über ein Aktivkohlefilter gereinigt wird.

8. Verfahren nach einem der Ansprüche 1 bis 7, dadurch gekennzeichnet, daß weitere metallische und/oder nichtmetallische Schichten aufgebracht werden.

9. Verfahren nach einem der Ansprüche 1 bis 8, dadurch gekennzeichnet, daß die Elektrolyten durch Anwendung von Unterdruck und/oder einer gegenüber der Elektrolytbetriebstemperatur erhöhten Temperatur einer Entgasungsbehandlung unterworfen wird.

10. Verfahren nach Anspruch 9, dadurch gekennzeichnet, daß die Entgasungsbehandlung durch Keimbildner und/oder Ultraschall unterstützt wird.

## Claims

1. A process for the electrochemical metallising of plastics surfaces, wherein the plastics surface to be metallised is metallised with a metallic conducting layer without an external current and following this is metallised electrolytically, characterised in that after metallising without an external current a semi-bright nickel layer is electrolytically deposited from a nickel sulphamate electrolyte, and following this a final electrolytic coating, particularly an electrolytic bright metal coating, is deposited on the plastics surface, with the proviso that there is no electrolytic deposition of a copper intermediate layer before the final electrolytic coating.

2. A process according to claim 1, characterised in that the semi-bright nickel layer is deposited at a layer thickness of 10 µm to 50 µm, preferably 20 µm.

3. A process according to claims 1 or 2, characterised in that the nickel sulphamate electrolyte is used in a composition in which sulphamate is replaced, at least in part, by corresponding salts of short-chain organic sulphonic acids.

4. A process according to any one of claims 1 to 3, characterised in that the nickel sulphamate electrolyte contains brightener additives.

5. A process according to any one of claims 1 to 4, characterised in that the semi-bright nickel layer is deposited to form the main part of the layer thickness in a first step at normal current density and is deposited up to the desired layer thickness in a subsequent, second step at a reduced current density.

6. A process according to claim 5, characterised in that different nickel sulphamate electrolytes are employed in the two steps.

7. A process according to any one of claims 1 to 6, characterised in that the nickel sulphamate electrolyte is continuously purified by passing it through an activated carbon filter.

8. A process according to any one of claims 1 to 7, characterised in that further metallic and/or nonmetallic layers are deposited.

9. A process according to any one of claims 1 to 8, characterised in that the electrolytes are subjected to a degassing treatment by the application of reduced pressure and/or by the use of a temperature which is higher than the operating temperature of the electrolyte.

10. A process according to claim 9, characterised in that the degassing treatment is assisted by nucleants and/or by ultrasound.

## Revendications

1. Procédé de métallisation de surfaces en matière plastique par voie galvanique, la surface en matière plastique à métalliser étant métallisée avec une couche conductrice métallique en l'absence de courant extérieur et étant ensuite métallisée par voie électrolytique, caractérisé en ce que, après la métallisation en l'absence de courant extérieur, une couche de nickel semi-brillant est déposée par voie électrolytique à partir d'un électrolyte sulfamate-nickel, et un revêtement terminal électrolytique, en particulier un revêtement électrolytique de métal brillant, est ensuite appliqué sur la surface en matière plastique, sachant que le dépôt électrolytique d'une couche intermédiaire de cuivre avant l'application du revêtement terminal électrolytique est supprimé.

2. Procédé selon la revendication 1, caractérisé en ce que la couche de nickel semi-brillant est appliquée avec une épaisseur de couche de 10 µm à 50 µm, de préférence de 20 µm.

3. Procédé selon la revendication 1 ou 2, caractérisé en ce que l'électrolyte sulfamate-nickel est mis en oeuvre dans une composition où le sulfamate est remplacé, au moins en partie, par les sels correspondants d'acides sulfoniques organiques à chaîne courte.

4. Procédé selon l'une des revendications 1 à 3, caractérisé en ce que l'électrolyte sulfamate-nickel contient des additifs aplanisseurs.

5. procédé selon l'une des revendications 1 à 4, caractérisé en ce que la couche de nickel semi-brillant est appliquée, dans une première étape, avec une densité de courant normale sur la majeure partie de l'épaisseur de la couche et, dans une seconde étape ultérieure, avec une densité de courant réduite jusqu'à l'épaisseur de couche nominale.

6. Procédé selon la revendication 5, caractérisé en ce que les deux étapes font intervenir des électrolytes sulfamate-nickel différents.

7. Procédé selon l'une des revendications 1 à 6, caractérisé en ce que l'électrolyte sulfamate-nickel est purifié en continu par un passage à travers un filtre au charbon actif.

8. Procédé selon l'une des revendications 1 à 7, caractérisé en ce que d'autres couches métalliques et/ou non métalliques sont appliquées.

9. Procédé selon l'une des revendications 1 à 8, caractérisé en ce que les électrolytes sont soumis à un traitement de dégazage par la mise en oeuvre d'une pression négative et/ou d'une température supérieure à la température d'utilisation de l'électrolyte.

10. Procédé selon la revendication 9, caractérisé en ce que le traitement de dégazage est favorisé par des agents de germination et/ou des ultrasons.
